Europäisches Patentamt

European Patent Office

Office européen des brevets

(19)

(11) Publication number: **0 066 466**
**B1**

(12) **EUROPEAN PATENT SPECIFICATION**

(45) Date of publication of patent specification: **16.04.86**

(51) Int. Cl.⁴: **G 03 F 1/00**

(21) Application number: **82302777.6**

(22) Date of filing: **28.05.82**

(54) **Photomask and method of testing it.**

(30) Priority: **01.06.81 JP 82538/81**

(43) Date of publication of application:
**08.12.82 Bulletin 82/49**

(45) Publication of the grant of the patent:
**16.04.86 Bulletin 86/16**

(84) Designated Contracting States:
**DE FR GB**

(56) References cited:
**IBM TECHNICAL DISCLOSURE BULLETIN, vol. 11, no. 12, May 1969, pages 1695-1696, New York, USA R.F. TYNAN: "Integrated circuit mask inspection technique"**
**IBM TECHNICAL DISCLOSURE BULLETIN, vol. 15, no. 10, March 1973, page 3205, New York, USA D.A. NEWCOMB et al.: "Image positioning"**
**SOLID-STATE TECHNOLOGY, vol. 21, no. 5, May 1978, pages 60-71, Washington, USA K. LEVY: "Automated equipment for 100% inspection of photomasks"**

(73) Proprietor: **FUJITSU LIMITED**
**1015, Kamikodanaka Nakahara-ku**
**Kawasaki-shi Kanagawa 211 (JP)**

(72) Inventor: **Kobayashi, Kenichi**
**6-34-3 Nagasaki**
**Toshima-ku Tokyo 171 (JP)**

(74) Representative: **Rackham, Stephen Neil et al**
**GILL JENNINGS & EVERY 53-64 Chancery Lane**
**London WC2A 1HN (GB)**

Courier Press, Leamington Spa, England.

## Description

The present invention relates to photomasks including reticles, used in the manufacture of semiconductor devices.

In general, a photomask has a large number of high-resolution images. If a photomask includes one or more defective images and is used in the manufacture of semiconductor devices, the manufacturing yield of semiconductor devices is reduced. Therefore, it is important to test the pattern on a photomask before it is used.

One conventional method for testing the pattern on a photomask is described in JP—A— 54—72975. In this specification a photomask is scanned and then the scanning signal obtained by scanning the pattern is compared with a reference scanning signal based on reference data stored in a storage unit such as a magnetic tape. In this case, the scanning of the pattern of the photomask is performed by moving a stage on which the photomask is mounted and monitoring light transmitted through the photomask. It is difficult to synchronise the scanning signal obtained by scanning the pattern of the photomask and the reference scanning signal read out of the magnetic tape, particularly as the motion of the stage is reversed during scanning. High accuracy of motion of the stage is required and this increases the cost of a unit for testing a photomask.

It is, therefore, the aim of this invention to provide a photomask and a method of testing it which would enable the cost of a unit for testing it to be reduced.

According to one aspect of this invention, a photomask for use in the manufacture of a semiconductor device comprises a photomask for use in manufacturing a semiconductor device comprising a pattern to be tested before being used in the manufacture of a semiconductor device, and an elongate synchronisation pattern formed on the photomask but not forming part of the pattern to be used in the manufacture of the semiconductor device for producing a synchronising pulse in a scanning signal generated during scanning of the pattern to be tested and comparison with a reference signal based on reference pattern data, the synchronisation pattern extending along at least one side of the pattern to be tested so that each scan always generates at least one synchronisating pulse, both the pattern and the synchronisation pattern being arranged within an area to be tested.

According to another aspect of this invention a method of testing a photomask for use in the manufacture of a semiconductor device in which the pattern of the photomask that is used to form the semiconductor device is tested by scanning it and comparing the scanning signal obtained during the scanning operation with a reference signal, is characterised in that the photomask includes an elongate synchronisation pattern extending along at least one side of the pattern of the photomask that is used to form the semiconductor device, in that at least one synchronisation pulse is generated in the scanning signal during each scan, and in that the synchronisation pulse produced in each scan by scanning the synchronisation pattern is used to synchronise the scanning signal with the reference signal for that scan.

A particular example of a method and various examples of photomasks in accordance with this invention will now be described with reference to the accompanying drawings; in which:—

Figures 1 to 8 are diagrams illustrating the patterns of various photomasks; and,

Figure 9 is a block circuit diagram of a unit for testing the pattern of a photomask.

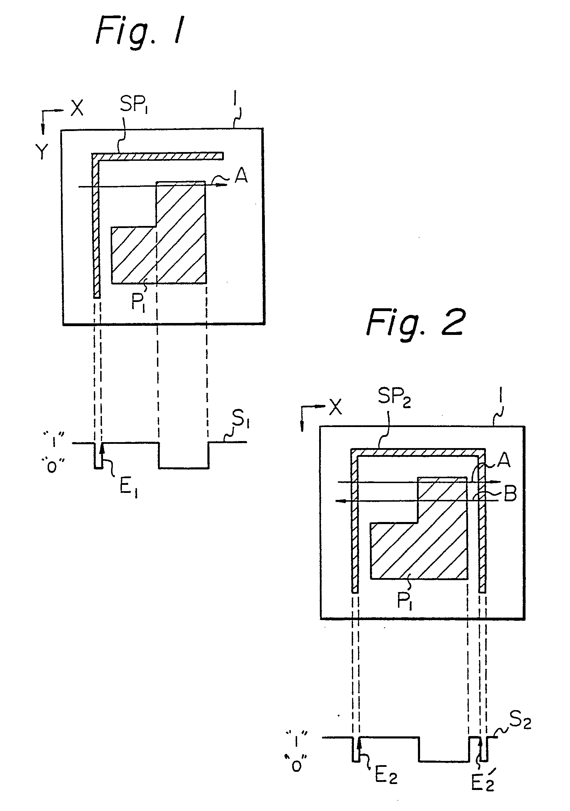

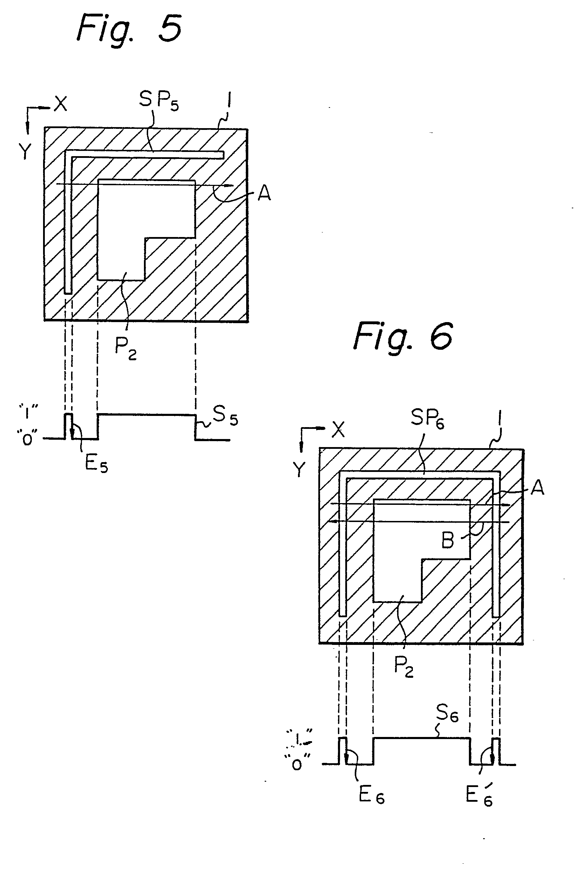

As illustrated in Figs. 1 through 4, if the pattern $P_1$ of a photomask 1 is dark, a dark synchronization pattern $SP_1$, $SP_2$ $SP_3$, or $SP_4$ is provided while, as illustrated in Figs. 5 through 8, if the pattern $P_2$ of the photomask 1 is light, a light synchronization pattern $SP_5$, $SP_6$, $SP_7$, or $SP_8$ is provided.

In Fig. 1, the synchronization pattern $SP_1$ is provided on the left side of the pattern $P_1$ in addition to the upper side thereof. In this case, the upper side portion of the pattern $SP_1$ is used for detecting the first position in the Y direction. Therefore, when scanning is performed in the X direction as indicated by the arrow, A, a scanning signal $S_1$ is obtained. In the signal $S_1$, the logic "0" level represents "dark" while the logic "1" level represents "light". By using the first rise edge $E_1$ due to the presence of the synchronization pattern $SP_1$, a comparison of the scanning signal $S_1$ and the reference scanning signal is initiated. Similarly, in Fig. 5, by using the first fall edge $E_5$, a comparison of the scanning signal $S_5$ and the reference scanning signal is initiated.

In Fig. 2, the synchronization pattern $SP_2$ is provided on both sides of the pattern $P_1$. Therefore, when scanning is performed in the traverse direction as indicated by the arrow A or B, a scanning signal $S_2$ is obtained. By using the first rise edge $E_2$ (or $E_2'$) due to the presence of the synchronization pattern $SP_2$, a comparison of the scanning signal $S_2$ and the reference scanning signal is initiated. Similarly, in Fig. 6, by using the first fall edge $E_6$ (or $E_6'$), a comparison of the scanning signal $S_6$ and the reference scanning signal is initiated.

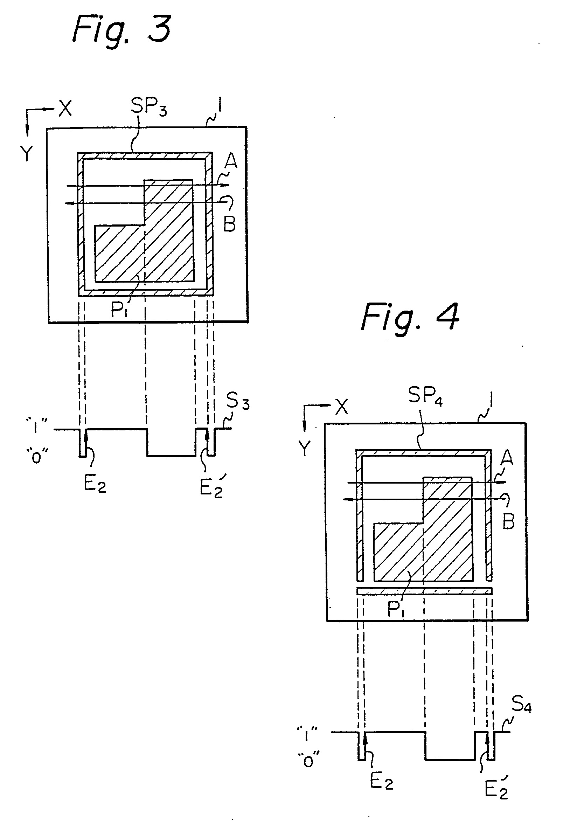

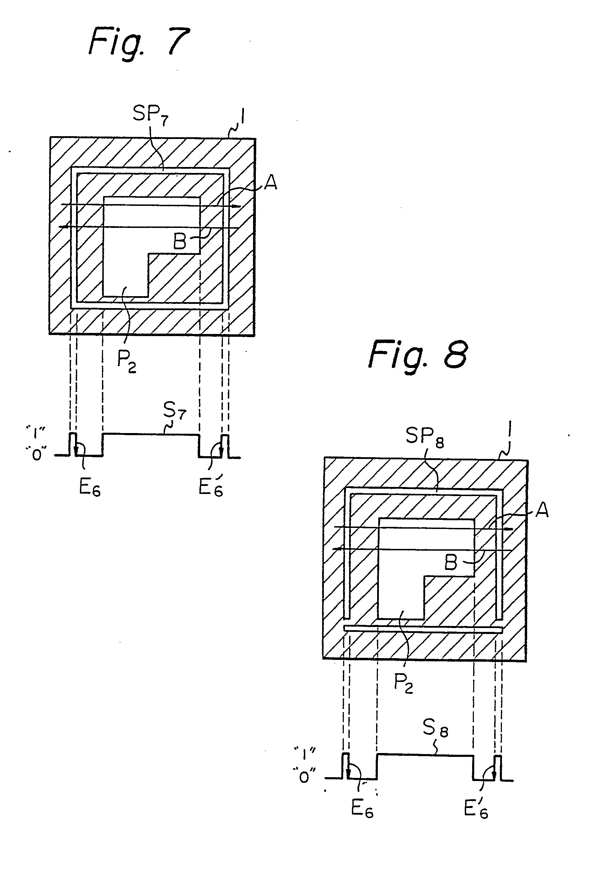

In Fig. 3, the synchronization pattern $SP_3$ is provided on the periphery of the pattern $P_1$, and in Fig. 7, the synchronization pattern $SP_7$ is also provided on the periphery of the pattern $P_2$. In this case, the lower side portion of the synchronization pattern $SP_3$ (or $SP_7$) is used for detecting the last position in the Y direction.

Figs. 4 and 8, the synchronization patterns $SP_4$ and $SP_8$ are asymmetrical in the Y direction. That is, discontinuities are present in the lower side of the patterns $SP_4$ and $SP_8$ and prevent the photomask 1 from being mounted upside down on a stage (not shown).

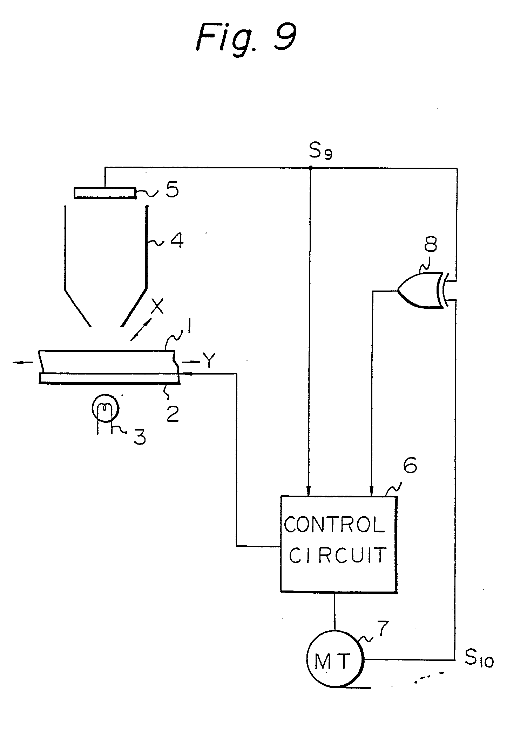

Figure 9 is a block diagram illustrating a unit for testing the pattern of a photomask according to the present invention. In Fig. 9, a photomask 1 is mounted on a stage 2. A light source 3 is located on one side of the photomask 1 while an optical system (lens) 4 and a photoelectric converter unit 5 which is comprised of, for example, one or more image sensors are arranged on the other side of the photomask 1. The stage 2 is driven by a control circuit 6. Reference numeral 7 indicates a magnetic tape for storing reference pattern data and reference numeral 8 indicates an exclusive OR circuit which serves as a comparison unit for comparing the scanning signal $S_9$ with the reference signal $S_{10}$ generated from the magnetic tape 7. Note that, in this case, the scanning signal $S_9$ is a digital signal.

The control circuit 6 is comprised of, for example, a microcomputer which comprises a central processing unit (CPU), a read-only memory (ROM) for storing constants , programs, and the like, and a random access memory (RAM) for storing intermediate data and the like.

The operation of the unit of Fig. 9 will now be explained. First, the control circuit 6 drives the stage 2 in the X direction so as to detect a synchronization pattern, for example, the synchronization pattern $SP_1$ of Fig. 1, in the scanning signal $S_9$. Next, when the edge $E_1$ of Fig. 1 is detected, the control circuit 6 performs a read operation upon the magnetic tape 7, which, in turn, generates the reference signal $S_{10}$ based on the reference pattern data stored in the magnetic tape 7. That is, each time such read operation is performed, the control circuit 6 shifts the stage 2 a predetermined distance. When the exclusive OR circuit 8 detects an inconsistency between the two signals $S_9$ and $S_{10}$, the control circuit 6 writes the position of the stage 2 into the RAM of the control circuit 6. That is, in the RAM of the control circuit 6, a failure map for indicating the position of the defective areas is formed.

In the unit of Fig. 9, the motion of the stage 2 follows the read operation of the magnetic tape 7 and therefore a high accuracy of motion of the stage 2 becomes unnecessary.

In addition, the synchronization pattern, particularly the upper portion thereof, is used for detecting the slope of the photomask 1. If the photomask 1 is inclined, a state of inconsistency often occurs. Such a state is detected by the control circuit 6. Further, the synchronization pattern can also be used for monitoring the exposure process, the etching process, and the like in the manufacture of a photomask, particularly in the case where the photomask has a complex pattern.

As was explained hereinbefore, the photomask according to the present invention is advantageous in that a high accuracy of motion of the stage is unnecessary, thereby reducing the cost of a unit for testing a photomask.

**Claims**

1. A photomask (1) for use in manufacturing a semiconductor device comprising a pattern ($P_1$, $P_2$) to be tested before being used in the manufacture of a semiconductor device, said testing comprising comparison with a reference signal ($S_{10}$) based on reference pattern data, characterised in that an elongate synchronisation pattern ($SP_1$ to $SP_8$) is provided on the photomask (1) not forming part of the pattern to be used in the manufacture of the semiconductor device for producing a synchronising pulse ($E_1$, $E_2$, $E_5$, $E_6$) in a scanning signal ($S_9$) generated during scanning of the pattern to be tested the synchronisation pattern extending along at least one side of the pattern to be tested so that each scan always generates at least one synchronisating pulse, both the pattern ($P_1$, $P_2$) and the synchronisation pattern ($SP_1$ to $SP_8$) being arranged within an area to be tested.

2. A photomask according to claim 1, wherein the synchronisation pattern ($SP_1$, $SP_5$) is provided only on one side of the pattern ($P_1$, $P_2$) to be tested.

3. A photomask according to claim 1, wherein the synchronisation pattern ($SP_2$, $SP_6$) is provided on both sides of the pattern ($P_1$, $P_2$) to be tested.

4. A photomask according to claim 4, wherein the synchronisation pattern ($SP_3$, $SP_7$) is provided around the periphery of the pattern ($P_1$, $P_2$) to be tested.

5. A photomask according to claim 4, wherein the synchronisation pattern ($SP_4$, $SP_8$) is asymmetric in a direction perpendicular to the scanning direction.

6. A photomask according to any one of the preceding claims, wherein the synchronisation pattern ($SP_1$ to $SP_4$) is opaque when the pattern ($P_1$) to be tested is opaque, or wherein the synchronisation pattern ($SP_5$ to $SP_8$) is transparent when the pattern ($P_2$) to be tested is transparent.

7. A method of testing a photomask (1) for use in the manufacture of a semiconductor device in which the pattern ($P_1$, $P_2$) of the photomask (1) that is used to form the semiconductor device is tested by scanning it and comparing the scanning signal ($S_9$) obtained during the scanning operation with a reference signal ($S_{10}$), characterised in that the photomask (1) includes an elongate synchronisation pattern ($SP_1$ to $SP_8$) extending along at least one side of the pattern ($P_1$, $P_2$) of the photomask (1) that is used to form the semiconductor device, in that at least one synchronisation pulse ($E_1$, $E_2$, $E_5$, $E_6$) is generated in the scanning signal ($S_9$) during each scan, and in that the synchronisation pulse produced in each scan by scanning the synchronisation pattern ($SP_1$ to $SP_8$) is used to synchronise the scanning signal ($S_9$) with the reference signal ($S_{10}$) for that scan.

8. A method of testing according to claim 7, in which the synchronisation pattern ($SP_1$ to $SP_8$) consists of two elongate portions extending in perpendicular directions and in which the orientation of the pattern on the photomask is checked by monitoring the scanning signal ($S_9$) obtained during scanning of the elongate portion of the synchronisation pattern ($SP_1$ to $SP_8$) extending in the scanning direction.

9. A method according to claim 7 or 8, in which reference data to produce the reference signal ($S_{10}$) is stored on a magnetic tape.

**Patentansprüche**

1. Fotomaske (1) für die Verwendung bei der Herstellung einer Halbleitervorrichtung, mit einem Muster ($P_1$, $P_2$), das getestet werden soll, bevor sie bei der Herstellung einer Halbleitervorrichtung verwendet wird, wobei dieses Testen einen Vergleich mit einem Referenzsignal ($S_{10}$) umfaßt, welches auf Referenzmusterdaten basiert, dadurch gekennzeichnet, daß ein längliches Synchronisationsmuster ($SP_1$ bis $SP_8$) auf der Fotomaske (1) vorgesehen ist, welches keinen Teil des Musters bildet, das zur Herstellung der Halbleitervorrichtung verwendet wird, zur Erzeugung eines Synchronisationsimpulses ($E_1$, $E_2$, $E_5$ $E_6$) in einem Abtastsignal ($S_9$), welches bei der Abtastung des zu testenden Musters erzeugt wird und welches Synchronisationsmuster sich längs wenigstens einer Seite des zu testenden Musters so erstreckt, daß jede Abtastung stets wenigstens einen Synchronisierungsimpuls erzeugt, und, daß beide, das Muster ($P_1$, $P_2$) und das Synchronisationsmuster ($SP_1$ bis $SP_8$) innerhalb eines zu testenden Bereichs angeordnet sind.

2. Fotomaske nach Anspruch 1, bei welcher das Synchronisationsmuster ($SP_1$, $SP_5$) nur auf einer Seite des zu testenden Musters ($P_1$, $P_2$) angeordnet ist.

3. Fotomaske nach Anspruch 1, bei welcher das Synchronisationsmuster ($SP_2$, $SP_6$) auf beiden Seiten des zu testenden Musters ($P_1$, $P_2$) angeordnet ist.

4. Fotomaske nach einem der Ansprüche 1 bis 3, bei welcher das Synchronisationsmuster ($SP_3$, $SP_7$) um den Umfang des zu testenden Musters ($P_1$, $P_2$) angeordnet ist.

5. Fotomaske nach Anspruch 4, bei welcher das Synchronisationsmuster ($SP_4$, $SP_8$) asymmetrisch in einer Richtung reachtwinklig zur Abtastrichtung ist.

6. Fotomaske nach einem der vorhergehenden Ansprüche, bei welcher das Synchronisationsmuster ($SP_1$ bis $SP_4$) undurchsichtig ist, wenn das zu testende Muster ($P_1$) undurchsichtig ist, oder bei welchem das Synchronisationsmuster ($SP_5$ bis $SP_8$) transparent ist, wenn das zu testende Muster ($P_2$) transparent ist.

7. Verfahren zum Testen einer Fotomaske (1) für die Verwendung bei der Herstellung einer Halbleitervorrichtung, bei welcher das Muster ($P_1$, $P_2$) der Fotomaske (1), die zur Bildung einer Halbleitervorrichtung verwendet wird, getestet wird durch Abtasten und Vergleich des Abtastsignals ($S_9$), welches während des Abtastvorganges erhalten wird, mit einem Referenzsignal ($S_{10}$), dadurch gekennzeichnet, daß die Fotomaske (1) ein längliches Synchronisationsmuster ($SP_1$ bis $SP_8$) umfaßt, welches sich wenigstens längs einer Seite des Musters ($P_1$, $P_2$) der Fotomaske (1) erstreckt, die zur Bildung einer Halbleitervorrich

tung verwendet wird, und daß wenigstens ein Synchronisationsimpuls ($E_1$, $E_2$, $E_5$, $E_6$) in dem Abtastsignal ($S_9$) während jeder Abtastung erzeugt wird, und daß Synchronisationsimpuls, der bei jeder Abtastung durch Abtasten des Synchronisationsmusters ($SP_1$ bis $SP_8$) erzeugt wird, zur Synchronisierung des Abtastsignals ($S_9$) mit dem Referenzsignal ($S_{10}$) für die Abtastung verwendet wird.

8. Verfahren zum Testen nach Anspruch 7, bei welchem das Synchronisationsmuster ($SP_1$ bis $SP_8$) aus zwei länglichen Abschnitten besteht, die sich in rechtwinkligen Richtungen erstrecken und bei welchen die Ausrichtung des Musters auf der Fotomaske durch Überwachung des Abtastsignals ($S_9$) geprüft wird, welches während der Abtastung des länglichen Abschnitts des Synchronisationsmusters ($SP_1$ bis $SP_8$) erhalten wird, das sich in der Abtastrichtung erstreckt.

9. Verfahren nach Anspruch 7 oder 8, bei welchem Referenzdaten zur Erzeugung des Referenzsignals ($S_{10}$) auf einem Magnetband gespeichert werden.

**Revendications**

1. Masque photographique (1) destiné à être utilisé pour la fabrication d'un dispositif semi-conducteur comprenant une configuration ($P_1$, $P_2$) devant être soumise à essai avant d'être utilisée pour la fabrication d'un dispositif semiconducteur, ladite opération d'essai comprenant la comparaison avec un signal de référence ($S_{10}$) provenant de données de configuration de référence, caractérisé en ce qu'il est prévu sur le masque photographique (1) une configuration de synchronisation allongée ($SP_1$ à $SP_8$) ne faisant pas partie de la configuration qui doit être utilisée pour la fabrication du dispositif semiconducteur afin de produire une impulsion de synchronisation ($E_1$, $E_2$, $E_5$, $E_6$) dans un signal de balayage ($S_9$) produit pendant le balayage de la configuration à soumettre à essai, la configuration de synchronisation s'étendant le long d'au moins un côté de la configuration à soumettre à essai, si bien que chaque balayage produit toujours au moins une impulsion de synchronisation, la configuration de synchronisation ($SP_1$ à $SP_8$) et la configuration ($P_1$, $P_2$) étant toutes deux disposées à l'intérieur d'une zone à soumettre à essai.

2. Masque photographique selon la revendication 1, où la configuration de synchronisation ($SP_1$, $SP_5$) n'est disposée que sur un côté de la configuration ($P_1$, $P_2$) à soumettre à essai.

3. Masque photographique selon la revendication 1, où la configuration de synchronisation ($SP_2$, $SP_6$) est disposée sur les deux côtés de la configuration ($P_1$, $P_2$) à soumettre à essai.

4. Masque photographique selon la revendication 4, où la configuration de synchronisation ($SP_3$, $SP_7$) est disposée sur la périphérie de la configuration ($P_1$, $P_2$) à soumettre à essai.

5. Masque photographique selon la revendication 4, où la configuration de synchronisation ($SP_4$,

SP$_8$) est asymétrique dans une direction perpendiculaire à la direction de balayage.

6. Masque photographique selon l'une quelconque des revendications précédentes, où la configuration de synchronisation (SP$_1$ à SP$_4$) est opaque lorsque la configuration (P$_1$) à soumettre à essai est opaque, ou bien où la configuration de synchronisation (SP$_5$ à SP$_8$) est transparente lorsque la configuration (P$_2$) à soumettre à essai est transparente.

7. Procédé permettant de soumettre à un essai un masque photographique (1) destiné à être utilisé pour la fabrication d'un dispositif semiconducteur, dans lequel on soumet à un essai la configuration (P$_1$, P$_2$) du masque photographique (1) qui est utilisée pour former le dispositif semicomducteur en balayant la configuration et en comparant le signal de balayage (S$_9$) obtenu pendant l'opération de balayage avec un signal de référence (S$_{10}$), caractérisé en ce que le masque photographique (1) comporte une configuration de synchronisation allongée (SP$_1$ à SP$_8$) s'étendant le long d'au moins un côté de la configuration (P$_1$, P$_2$) du masque photographique (1) qui est utilisée pour former le dispositif semiconducteur, en ce qu'au moins une impulsion de synchronisation (E$_1$, E$_2$, E$_5$, E$_6$) est produite dans le signal de balayage (S$_9$) pendant chaque balayage, et en ce qu'on utilise l'impulsion de synchronisation produite dans chaque balayage par le balayage de la configuration de synchronisation (SP$_1$ à SP$_8$) pour synchroniser le signal de balayage (S$_9$) avec le signal de référence (S$_{10}$) pendant ce balayage.

8. Procédé d'essai selon la revendication 7, dans lequel la configuration de synchronisation (SP$_1$ à SP$_8$) est constituée de deux parties allongées s'étendant suivant des directions perpendiculaires et dans lequel on vérifie l'orientation de la configuration se trouvant sur le masque photographique en contrôlant le signal de balayage (S$_9$) obtenu pendant le balayage de la partie allongée de la configuration de synchronisation (SP$_1$ à SP$_8$) s'étendant suivant la direction de balayage.

9. Procédé selon la revendication 7 ou 8, dans lequel les données de référence servant à produire le signal de référence (S$_{10}$) sont emmagasinées sur une bande magnétique.

# Fig. 1

# Fig. 2

# Fig. 3

# Fig. 4

## Fig. 5

## Fig. 6

# Fig. 7

# Fig. 8

# Fig. 9